# EUROPEAN PATENT APPLICATION

(11) **EP 4 746 013 A1**
(43) Date of publication of application: **20.05.2026**
(21) Application number: 25216073.4
(22) Date of filing: 14.11.2025
(51) Int. Cl.: H01H 13/705

(54) **HOUSING ASSEMBLY, MOVABLE ENERGY STORAGE APPARATUS, AND ENERGY STORAGE SYSTEM**

(30) Priority: 15.11.2024 CN 202411640425
(71) Applicant: Shenzhen Hithium Hero Energy Equity Technology Co., Ltd, Shenzhen, Guangdong 518110 (CN); Xiamen Hithium Energy Storage Technology Co., Ltd., Xiamen, Fujian 361100 (CN)
(72) Inventor: HUANG, Shuisheng, Shenzhen, 518110 (CN); DAI, Wei, Shenzhen, 518110 (CN)
(74) Representative: Mewburn Ellis LLP

(57) **Abstract**

A housing assembly (10), a mobile energy storage apparatus (100), and an energy storage system (1000) are provided. The housing assembly (10) includes a first housing (11), a button structure (12), and a circuit board (13). The first housing (11) is provided with a first fixing portion (112) on an inner surface of the first housing (11). The button structure (12) includes a button body (121) passing through a button via hole (111) of the first housing (11) and a resilient arm (122). The button body (121) is provided with a button protrusion (1211). The circuit board (13) is positioned at one side of the button structure (12) positioned facing away from the button via hole (111). The circuit board (13) is provided with a control button (131) positioned facing towards the button structure (12). One of the circuit board (13) and a fixing end (1222) of the resilient arm (122) is provided with a positioning portion (132), and the other of the circuit board (13) and the fixing end (1222) is provided with a fitting portion (1223).

## Description

### TECHNICAL FIELD

This disclosure relates to the field of energy storage technologies, and in particular, to a housing assembly, a movable energy storage apparatus, and an energy storage system.

### BACKGROUND

In the related art, energy storage products generally have input and output interfaces arranged on housings to implement charging and discharging functions of the energy storage products. In addition, to facilitate a user to control such an energy storage product to implement certain functions, for example, to implement turning on, turning off, charging, discharging, lighting, display, etc., of the energy storage product, buttons, such as switchboard buttons, direct current (DC) output switch buttons, alternating current (AC) output switch buttons, lighting lamp switch buttons, display screen switch buttons, or the like, are generally provided on the housing of the energy storage product, so that the user can operate the energy storage product to perform corresponding operations by pressing the buttons on the housing.

However, in the related art, button protrusions on the buttons are prone to deviation and misalignment with button contacts on a circuit board, which easily causes the buttons to malfunction due to deviation when pressed, thereby affecting the control effect of the buttons.

### SUMMARY

A housing assembly, a mobile energy storage apparatus, and an energy storage system are disclosed in embodiments of the present disclosure, which can realize precise alignment between a button protrusion on a button structure and a control button on a circuit board within a limited spatial range, so as to improve the control effect of the button structure.

In order to achieve the described object, in a first aspect, the present disclosure discloses a housing assembly. The housing assembly includes a first housing, a button structure, and a circuit board. The first housing defines a button via hole communicating an interior of the first housing with an exterior of the first housing. The first housing is provided with a first fixing portion on an inner surface of the first housing. The button structure includes a button body and a resilient arm. The button body passes through the button via hole. The button body is provided with a button protrusion protruding towards the interior of the first housing. The resilient arm is positioned inside the first housing. The resilient arm has a connecting end and a fixing end opposite to the connecting end in an extension direction of the resilient arm. The connecting end is connected to the button body. The fixing end is connected to the first fixing portion. The circuit board is disposed inside the first housing and is positioned at one side of the button structure positioned facing away from the button via hole. The circuit board is provided with a control button protruding from a surface of the circuit board positioned facing towards the button structure. The control button is positioned at a position corresponding to the button protrusion. One of the circuit board and the fixing end is provided with a positioning portion, and the other of the circuit board and the fixing end is provided with a fitting portion. The fitting portion passes through the positioning portion, so that the control button is aligned with the button protrusion.

In the housing assembly provided in the present disclosure, the button structure and the circuit board included therein are arranged inside the first housing by means of stacked assembly. In addition, the positioning portion is provided at one of the circuit board and the fixing end of the resilient arm of the button structure, and the fitting portion is provided at the other of the circuit board and the fixing end. Therefore, by means of the mutual fitting between the positioning portion and the fitting portion, the button structure and the circuit board can be precisely positioned, so as to ensure the accurate positioning between the button structure and the circuit board. Furthermore, it is ensured that the button protrusion on the button structure can be aligned with the control button on the circuit board, so that the button structure is prevented from malfunction, so as to ensure the control effect of the button structure.

As an optional implementation, in an embodiment of the first aspect of the present disclosure, the circuit board abuts against the fixing end in a depth direction of the button via hole. By arranging the fixing end of the button structure to abut against the circuit board, the fixing end cannot only provide an arrangement position for the positioning structure (i.e., the fitting portion and the positioning portion) of the circuit board, so as to serve as a positioning site for the circuit board, but also provide a supporting force for the circuit board, thereby preventing the circuit board from being squeezed or even experiencing circuit failure, and improving the stability of the whole structure.

As an optional implementation, in an embodiment of the first aspect of the present disclosure, the circuit board is provided with a second fixing portion, and the second fixing portion is connected to the fixing end, to make the circuit board fixed inside the first housing.

Since the button structure is positioned between the circuit board and the inner surface of the first housing, if the circuit board is directly connected to the inner surface of the first housing, in order to avoid being blocked by the button structure, the area of the circuit board is usually increased so as to reserve a position on the circuit board 13 staggered with the button structure as a position for connection with the first housing. That is, the circuit board has a connection position beyond the periphery of the button structure and is not blocked by the button structure. However, in this way, it is easy to increase the occupation of the space of the first housing by the circuit board, which is not conducive to miniaturized design. Therefore, by connecting the second fixing portion and the fixing end, the circuit board can be fixed and connected to the first housing, and the area of the circuit board does not need to be increased additionally, which facilitates a miniaturized design of the circuit board and reduces occupation of an internal space of the first housing by the circuit board. Thus, the miniaturized design of the housing assembly is implemented, so that the housing assembly can be applicable to a mobile energy storage apparatus of a miniaturized design, thereby facilitates a user to carry the mobile energy storage apparatus by hand.

As an optional implementation, in an embodiment of the first aspect of the present disclosure, the resilient arm is implemented as multiple resilient arms arranged at intervals in a circumferential direction of the button body. The first fixing portion is implemented as multiple first fixing portions. The multiple first fixing portions are respectively connected to fixing ends of the multiple resilient arms. In this way, the button body can be connected to the first housing through the multiple resilient arms, so that the force applied to the button body when being pressed can be more dispersed and even, thereby avoiding a situation in which the pressing failure occurs due to uneven force applied to the button structure in the pressing process. Thus, the accuracy of the pressing of the button structure is ensured, the button structure is prevented from malfunction to not affect the function of the mobile energy storage apparatus, and the use experience of the user is improved.

As an optional implementation, in an embodiment of the first aspect of the present disclosure, fixing ends of any adjacent two of the multiple resilient arms are connected through a connecting rib; or the number of the resilient arms is an even number, the fixing ends of every two of the multiple resilient arms are connected through a connecting rib, and a fixing end of each of the multiple resilient arms is connected to one connecting rib.

When the fixing ends of any two adjacent resilient arms are connected through the connecting rib, any two adjacent resilient arms can form one square-shaped structure together with the button body, and the structure can be more stable, thereby improving the overall structural stability of the button structure, and further effectively preventing the problem of button malfunction caused by the deviation of the button structure in the pressing process. When the number of the resilient arms is the even number, and the fixing ends of two resilient arms are connected through the connecting rib, although it is impossible for any two adjacent resilient arms to form one square-shaped structure together with the button body, each resilient arm and another resilient arm can form one square-shaped structure together with the button body, so that no resilient arm is left alone or independent and excluded from being part of the square-shaped structure, and likewise the overall structure of the button structure can be relatively stable, so as to prevent the problem of button malfunction caused by the deviation of the button structure in the pressing process.

As an optional implementation, for two resilient arms connected to each other through the connecting rib, a fixing end of one of the two resilient arms is connected to one of the multiple first fixing portions, and a fixing end of the other of the two resilient arms is not connected to one of the multiple first fixing portions and is provided with the fitting portion or the positioning portion.

In this way, the two resilient arms connected through the connecting rib may be connected to the first housing by means of one of the two resilient arms connected to the first fixing portion. Thus, even if the other of the two resilient arms is not fixed and connected to the first housing, deformation of the other of the two resilient arms when the button body is pressed is not affected. That is, when the button body is pressed, the other of the two resilient arms not fixed and connected to the first housing can still be deformed, thereby distributing the force applied to the button body. Meanwhile, since the positioning portion or the fitting portion is disposed at the fixing end that is not connected to the first housing, that is, since the positioning portion or the fitting portion is not disposed at the fixing end that is connected to the first fixing portion, the fixing end can have a sufficient space to be connected to the first fixing portion. Therefore, the interference of the positioning portion or the fitting portion on the fixed connection between the fixing end and the first fixing portion is avoided, so that the connection reliability between the fixing end and the first fixing portion is ensured.

As an optional implementation, in an embodiment of the first aspect of the present disclosure, the circuit board has a first preset direction and a second preset direction that are defined at an angle. A size of the circuit board in the first preset direction is larger than or equal to a size of the circuit board in the second preset direction. Two ends of the circuit board in the first preset direction are connected to the first housing. The button structure includes a first sub-button and a second sub-button spaced apart from each other in the first preset direction. Each of the first sub-button and the second sub-button includes the button body and the multiple resilient arms. The button body of the first sub-button has a first side and a second side opposite to the first side in the first preset direction. The second side is closer to the second sub-button than the first side. The second sub-button has a third side and a fourth side opposite to the third side in the first preset direction. The third side is closer to the first sub-button than the fourth side. The multiple resilient arms of the first sub-button include a first resilient sub-arm and a second resilient sub-arm. The first resilient sub-arm is disposed at the first side. The second resilient sub-arm is disposed at the second side. The multiple resilient arms of the second sub-button include a third resilient sub-arm and a fourth resilient sub-arm. The third resilient sub-arm is disposed at the third side. The fourth resilient sub-arm is disposed at the fourth side. A length of the first resilient sub-arm in an extension direction of the first resilient sub-arm is larger than a length of the second resilient sub-arm in an extension direction of the second resilient sub-arm, and/or a length of the fourth resilient sub-arm in an extension direction of the fourth resilient sub-arm is larger than a length of the third resilient sub-arm in an extension direction of the third resilient sub-arm.

In the present disclosure, the size of the circuit board in the first preset direction is larger than or equal to the size of the circuit board in the second preset direction, only two ends of the circuit board in the first preset direction is fixed and connected to the first housing, and there is no connecting position or supporting position at the middle position of the circuit board in the first preset direction. Meanwhile, according to mechanical principles, when the resilient arm is longer, the moment is greater. Thus, since the length of the first resilient sub-arm in the extension direction of the first resilient sub-arm is larger than the length of the second resilient sub-arm in the extension direction of the second resilient sub-arm, the first resilient sub-arm can be more easily subjected to a force and is more deformed than the second resilient sub-arm, so that in the process of the user pressing the first sub-button, the overall stress can be distributed more on the first resilient sub-arm. Considering that the first resilient sub-arm is close to one end of the circuit board in the first preset direction, one end of the circuit board in the first preset direction can be first subjected to the force, that is, one end of the circuit board connected and fixed to the first housing is first subjected to the force. In this way, the circuit board is prevented from being subjected to a force first at a position which is deviated from the center and lacks connection and support in the first preset direction, thereby reducing the risk of deformation or even fracture of the circuit board.

Similarly, since the length of the fourth resilient sub-arm in the extension direction of the fourth resilient sub-arm is larger than the length of the third resilient sub-arm in the extension direction of the third resilient sub-arm, the fourth resilient sub-arm is more easily subjected to a force and is more deformed than the third resilient sub-arm, so that in the process of the user pressing the second sub-button, the overall stress can be distributed more on the fourth resilient sub-arm. Considering that the fourth resilient sub-arm is close to the other end of the circuit board in the first preset direction, the other end of the circuit board in the first preset direction can be first subjected to the force, that is, the other end of the circuit board connected and fixed to the first housing is first subjected to the force. In this way, the circuit board is prevented from being subjected to the force first at a position which is deviated from the center and lacks connection and support in the first preset direction, thereby reducing the risk of deformation or even fracture of the circuit board.

As an optional implementation, in an embodiment of the first aspect of the present disclosure, the first resilient sub-arm and the second resilient sub-arm are symmetrically disposed. The third resilient sub-arm and the fourth resilient sub-arm are disposed symmetrically. In this way, the button structure can be subjected to the force more evenly at the two sides of the circuit board in the first preset direction respectively, thereby avoiding the problem of button malfunction caused by the deviation of the button structure in the pressing process.

As an optional implementation, in an embodiment of the first aspect of the present disclosure, the number of the multiple first fixing portions is less than the number of the multiple resilient arms.

The first resilient sub-arm is connected to the second resilient sub-arm through a connecting rib. A fixing end of the first resilient sub-arm is connected to a first fixing portion. A fixing end of the second resilient sub-arm is not connected to the first housing through a first fixing portion. The fixing end of the first resilient sub-arm is connected to one end of the circuit board in the first preset direction. The fixing end of the second resilient sub-arm is provided with the positioning portion or the fitting portion. In this way, the second resilient sub-arm may be connected to the first housing by means of the first resilient sub-arm, so that even if the second resilient sub-arm is not fixed and not connected to the first housing, deformation of the second resilient sub-arm when the button body is pressed is not affected. That is, when the button body is pressed, the second resilient sub-arm that is not fixed and not connected to the first housing can still be deformed, thereby distributing the force applied to the button body of the first sub-button. Meanwhile, since the positioning portion or the fitting portion is disposed at the fixing end that is not connected to the first housing and the circuit board, that is, since the positioning portion or the fitting portion is not disposed at the fixing end connected to the first fixing portion and the circuit board, the fixing end has a sufficient space to be connected to the first fixing portion and the circuit board. Therefore, the interference of the positioning portion or the fitting portion on the fixed connection between the fixing end and each of the first fixing portion and the circuit board is avoided, so that the connection reliability between the fixing end and each of the first fixing portion and the circuit board is ensured.

The third resilient sub-arm is connected to the fourth resilient sub-arm through a connecting rib. A fixing end of the fourth resilient sub-arm is connected to a first fixing portion. A fixing end of the third resilient sub-arm is not connected to the first housing through a first fixing portion. The fixing end of the fourth resilient sub-arm is connected to the other end of the circuit board in the first preset direction. The fixing end of the third resilient sub-arm is provided with the positioning portion or the fitting portion. In this way, the third resilient sub-arm may be connected to the first housing by means of the fourth resilient sub-arm, so that even if the third resilient sub-arm is not fixed and not connected to the first housing, deformation of the third resilient sub-arm when the button body is pressed is not affected. That is, when the button body is pressed, the third resilient sub-arm that is not fixed and not connected to the first housing can still be deformed, thereby distributing the force applied to the button body of the second sub-button. Meanwhile, since the positioning portion or the fitting portion is disposed at the fixing end that is not connected to the first housing and the circuit board, that is, since the positioning portion or the fitting portion is not disposed at the fixing end connected to the first fixing portion and the circuit board, the fixing end has a sufficient space to be connected to the first fixing portion and the circuit board. Therefore, the interference of the positioning portion or the fitting portion on the fixed connection between the fixing end and each of the first fixing portion and the circuit board is avoided, so that the connection reliability between the fixing end and each of the first fixing portion and the circuit board is ensured.

As an optional implementation, in an embodiment of the first aspect of the present disclosure, the button structure includes a first sub-button and a second sub-button. Each of the first sub-button and the second sub-button includes the button body and the resilient arm. The fixing end of the first sub-button is configured as a first fixing end. The fixing end of the second sub-button is configured as a second fixing end. At least one of the first fixing end or the second fixing end is provided with a first foolproof portion. The first housing is provided with a second foolproof portion on the inner surface of the first housing. One of the first foolproof portion and the second foolproof portion is a foolproof protrusion, and the other of the first foolproof portion and the second foolproof portion is a foolproof slot. The foolproof protrusion is embedded in the foolproof slot.

In this way, by means of the fitting between the foolproof protrusion and the foolproof slot, an effective foolproof function is provided for the assembly of the first sub-button and the second sub-button, thereby preventing the first sub-button from being assembled into a second sub via hole and preventing the second sub-button from being assembled into a first sub via hole in the assembly process. Therefore, assembly errors of the first sub-button and the second sub-button are avoided, thereby effectively preventing a situation in which a preset function is not matched and errors occur when a target button is pressed, so as to ensure the control accuracy of the first sub-button and the second sub-button.

As an optional implementation, in an embodiment of the first aspect of the present disclosure, only one of the first fixing end and the second fixing end is provided with the first foolproof portion. In this way, in the assembly process, when the first sub-button and the second sub-button are mounted in reverse, the foolproof protrusion may be blocked by a surface without the foolproof slot, so that the first sub-button or the second sub-button cannot be mounted, thereby prompting the mounting personnel that the first sub-button and the second sub-button are mounted backwards, and achieving a foolproof mounting effect for the button structure. Furthermore, the fitting between the foolproof protrusion and the foolproof slot not only provides the foolproof function but also provides a positioning function. Alternatively, each of the first fixing end and the second fixing end is provided with the first foolproof portion. The first foolproof portion on the first fixing end and the first foolproof portion on the second fixing end are different in shape, and/or the first foolproof portion on the first fixing end and the first foolproof portion on the second fixing end are different in size. In this way, in the assembly process, only when the first foolproof portion and the second foolproof portion have the same shape and/or size, the first foolproof portion can be fitted and mounted with the second foolproof portion. At this time, both the first fixing end and the second fixing end are not blocked by the foolproof protrusion, so that the button body of the first sub-button and the button body of the second sub-button can be smoothly mounted into the corresponding button via hole to be mounted on the first housing. Furthermore, the first foolproof portion and the second foolproof portion in different shapes cannot be mounted, thereby preventing the first sub-button and the second sub-button from being mounted backwards, and achieving the foolproof mounting effect for the button structure.

As an optional implementation, in an embodiment of the first aspect of the present disclosure, the first fixing portion is a protrusion protruding from the inner surface of the first housing. The second foolproof portion is the foolproof protrusion. The foolproof protrusion is connected to the first fixing portion on an outer peripheral surface of the first fixing portion. A surface, positioned facing away from the circuit board, of the first fixing end and/or the second fixing end is recessed to define a positioning recess. The first foolproof portion is the foolproof slot in communication with the positioning recess. The foolproof slot extends through the surface, positioned facing away from the circuit board, of the first fixing end and/or the second fixing end. The first fixing portion is embedded in the positioning recess. The second foolproof portion is embedded in the first foolproof portion.

By adopting the described design mode, the first sub-button and the second sub-button can be prevented from being mounted backwards by means of the fitting between the foolproof protrusion and the foolproof slot, and the foolproof guide function is provided for the mounting of the first sub-button and the second sub-button, thereby improving the mounting precision of the first sub-button and the second sub-button. In addition, the foolproof protrusion can be in fit with the foolproof slot to achieve a foolproof mounting effect, and can also serve as a reinforcing rib of the first fixing portion to reinforce structural strength of the first fixing portion, thereby improving connection reliability of the button structure and the circuit board on the first housing.

In a second aspect, the present disclosure discloses a mobile energy storage apparatus. The mobile energy storage apparatus includes a second housing, an energy storage unit, and the housing assembly as described in the first aspect. The second housing is connected to the first housing. The second housing and the first housing cooperatively define an inner cavity therebetween. The energy storage unit is built in the inner cavity. The circuit board is electrically connected to the energy storage unit. The movable energy storage apparatus having the housing assembly in the first aspect can also achieve, within a limited spatial range, precise alignment between the button protrusion on the button structure and the control button on the circuit board, thereby improving the control effect of the button structure.

In a third aspect, the present disclosure discloses an energy storage system. The energy storage system has the mobile energy storage apparatus described in the second aspect. For the energy storage system having the mobile energy storage apparatus in the second aspect, since the mobile energy storage apparatus has the same or similar beneficial effect as the housing assembly in the first aspect, the energy storage system having the mobile energy storage apparatus in the second aspect can achieve, within a limited spatial range, precise alignment between the button protrusion on the button structure and the control button on the circuit board, thereby improving the control effect of the button structure.

Compared with the related art, the present disclosure has the following beneficial effects. For the housing assembly, the mobile energy storage apparatus, and the energy storage system, the button structure and the circuit board are arranged inside the first housing by means of the stacked assembly. In addition, the positioning portion is provided at one of the circuit board and the fixing end of the resilient arm of the button structure, and the fitting portion is provided at the other of the circuit board and the fixing end. Therefore, by means of the mutual fitting between the positioning portion and the fitting portion, the button structure and the circuit board can be precisely positioned, so as to ensure the accurate positioning between the button structure and the circuit board. Furthermore, it is ensured that the button protrusion on the button structure can be aligned with the control button on the circuit board, so that the button structure is prevented from malfunction, so as to ensure the control effect of the button structure.

### BRIEF DESCRIPTION OF THE DRAWINGS

In order to describe technical solutions in embodiments of the present disclosure more clearly, the following will give a brief description of accompanying drawings used for describing the embodiments. Apparently, the accompanying drawings described below merely illustrate some embodiments of the present disclosure. Those of ordinary skill in the art can also obtain other accompanying drawings based on the accompanying drawings described below without creative efforts.
FIG. 1 is a schematic structural view of an energy storage system disclosed in an embodiment of the present disclosure.
FIG. 2 is an exploded schematic structural view of a mobile energy storage apparatus disclosed in an embodiment of the present disclosure.
FIG. 3 is a schematic structural view of a housing assembly disclosed in an embodiment of the present disclosure.
FIG. 4 is an exploded schematic structural view of a housing assembly disclosed in an embodiment of the present disclosure.
FIG. 5 is an exploded structural schematic view of a housing assembly disclosed in an embodiment of the present disclosure from another perspective.
FIG. 6 is a top view of a housing assembly disclosed in an embodiment of the present disclosure.
FIG. 7 is a cross-sectional view of the housing assembly in FIG. 6 taken along line A-A.
FIG. 8 is a schematic structural view of a button structure including two resilient arms disclosed in an embodiment of the present disclosure.
FIG. 9 is a schematic structural view of a button structure including four resilient arms disclosed in an embodiment of the present disclosure.
FIG. 10 is a schematic structural view of a housing assembly disclosed in an embodiment of the present disclosure from another perspective.
FIG. 11 is an exploded view of the housing assembly in FIG. 10.
FIG. 12 is a schematic structural view of a first housing disclosed in an embodiment of the present disclosure.
FIG. 13 is a schematic structural view of a button structure including a first sub-button and a second sub-button disclosed in an embodiment of the present disclosure.
FIG. 14 is a schematic structural view of a button structure including a first sub-button and a second sub-button disclosed in an embodiment of the present disclosure from another perspective.
FIG. 15 is a is a block view of an energy storage system disclosed in an embodiment of the present disclosure.

Key reference signs in the accompanying drawings are described as follows: 1000 - energy storage system; 100 - mobile energy storage apparatus; 10 - housing assembly; 11 - first housing; 111 - button via hole; 111a - first sub via hole; 111b - second sub via hole; 112 - first fixing portion; 112a - first fixing sub-portion; 112b - second fixing sub-portion; 1121 - first threaded hole; 1122 - threaded seat; 113 - second foolproof portion; 12 - button structure; 12a - first sub-button; 12b - second sub-button; 121 - button body; 121a - first side; 121b - second side; 121c - third side; 121d - fourth side; 1211 - button protrusion; 122 - resilient arm; 122a - first resilient sub-arm; 122b - second resilient sub-arm; 122c - third resilient sub-arm; 122d - fourth resilient sub-arm; 1221 - connecting end; 1222 - fixing end; 1222a - first fixing end; 1222b - second fixing end; 1223 - fitting portion; 1224 - first through hole; 1225 - ; 1226 - first foolproof portion; 123 - connecting rib; 13 - circuit board; 131 - control button; 132 - positioning portion; 133 - second fixing portion; 133a - second through hole; 14 - first threaded member; 20 - second housing; 21 - inner cavity; 30 - energy storage unit; f1 - first preset direction; f2 - second preset direction.

### DETAILED DESCRIPTION

In order to make the purposes, technical solutions, and advantages of the present disclosure clearer, the following will describe the present disclosure in detail with a combination of accompanying drawings and embodiments. It should be understood that, specific embodiments described herein are merely for explaining, rather than limiting, the present disclosure.

Unless otherwise defined, all technical and scientific terms used herein have the same meaning as commonly understood by one of ordinary skill in the technical field to which the present disclosure belongs. The terms used herein are only for describing the purpose of embodiments of the present disclosure, and are not intended to limit the present disclosure.

It can be understood that terms "first", "second", and the like used in the present disclosure are used to describe various elements, but these elements are not limited by these terms. The terms are only used to distinguish a first element from another element. For example, without departing from the scope of the present disclosure, a first button may be referred to as a second button, and similarly, the second button may be referred to as the first button. Both the first button and the second button are buttons, but they are not the same button.

It can be understood that, in the following embodiments, if there are electric signals or data transmissions among connected circuits, modules, and units, "connection" should be understood as "electrical connection", "communication connection", and so on.

As used herein, unless otherwise clearly stated in the context, singular forms "a", "an", and "the" can also include plural forms. It should also be noted that, the term "include/contain" or "have" is used to clearly indicate existence of the feature, integer, step, operation, assembly, component, or groups thereof, but does not exclude existence or addition of one or more other features, integers, steps, operations, assemblies, components, or groups thereof. Meanwhile, the term "and/or" used in this specification is merely an associative relationship describing associated objects, indicating that there may be three relationships, for example, A and/or B may indicate three cases: A alone, A and B, and B alone. That is, the term "and/or" used in this specification includes any and all combinations of the items listed in the related art.

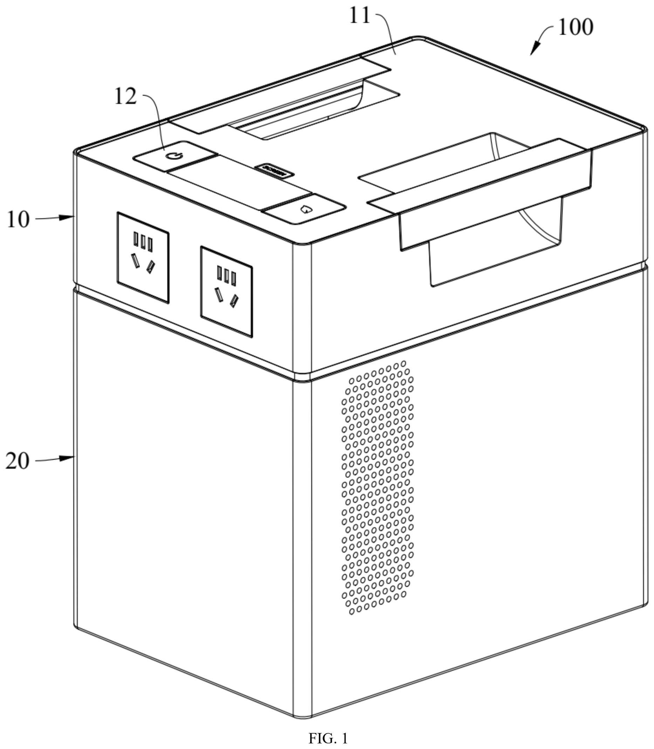

Referring to FIG. 1, an embodiment of the present disclosure discloses an energy storage apparatus 100, such as a mobile energy storage apparatus 100, and in particular, a mobile energy storage apparatus 100 with a miniaturized design, so that a user can carry the mobile energy storage apparatus 100 by hand, thereby facilitating moving the position of the mobile energy storage apparatus 100.

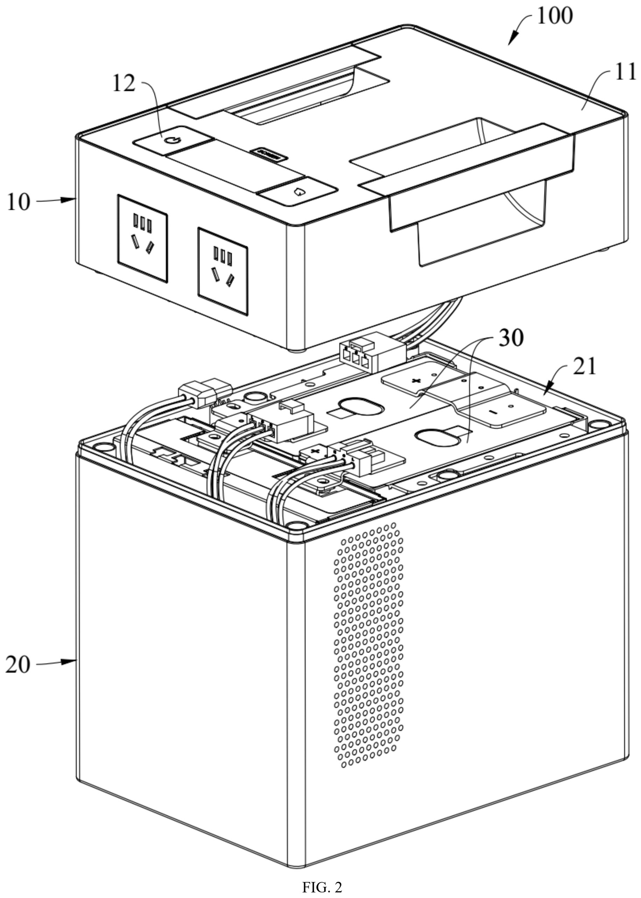

Referring to FIG. 1 and FIG. 2, a mobile energy storage apparatus 100 provided by an embodiment of the present disclosure may include a housing assembly 10, a second housing 20, and an energy storage unit 30. The second housing 20 is connected to the housing assembly 10. The second housing 20 and the housing assembly 10 cooperatively define an inner cavity 21 therebetween. The energy storage unit 30 is built in the inner cavity 21 to prevent the energy storage unit 30 from being exposed to the environment, thereby protecting the energy storage unit 30.

As an embodiment, the housing assembly 10 may serve as a top housing assembly of the mobile energy storage apparatus 100, and the second housing 20 may serve as a bottom housing of the mobile energy storage apparatus 100. As another embodiment, the housing assembly 10 may serve as a bottom housing assembly of the mobile energy storage apparatus 100, and the second housing 20 may serve as a top housing of the mobile energy storage apparatus 100.

Optionally, the energy storage unit 30 may include one or more cells. When the energy storage unit 30 includes multiple cells, for example, two, three, four, five, six, or more cells, the multiple cells may be arranged in a straight line in the first direction, or may be arranged in an array in the first direction and the second direction. In addition, the multiple cells may be connected to each other in series or in parallel. Exemplarily, as illustrated in FIG. 2, the second housing 20 has a cuboid structure. The energy storage unit 30 includes two cells connected in series, each cell has a cuboid structure, and the two cells connected in series are arranged in the first direction.

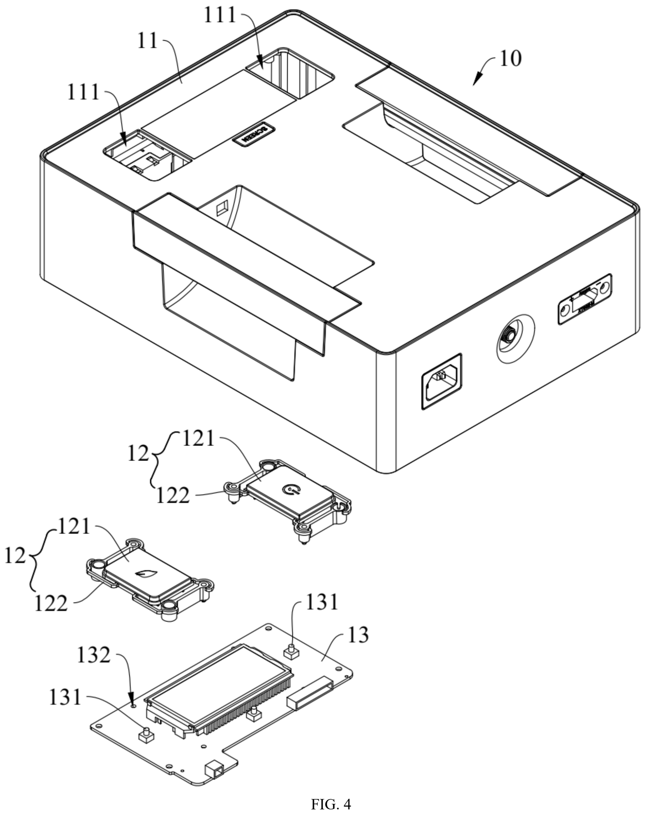

Referring to FIG. 2 to FIG. 4, the housing assembly 10 provided in an embodiment of the present disclosure includes a first housing 11, a button structure 12, and a circuit board 13. The first housing 11 is connected to the second housing 20. The first housing 11 and the second housing 20 cooperatively define the inner cavity 21 therebetween.

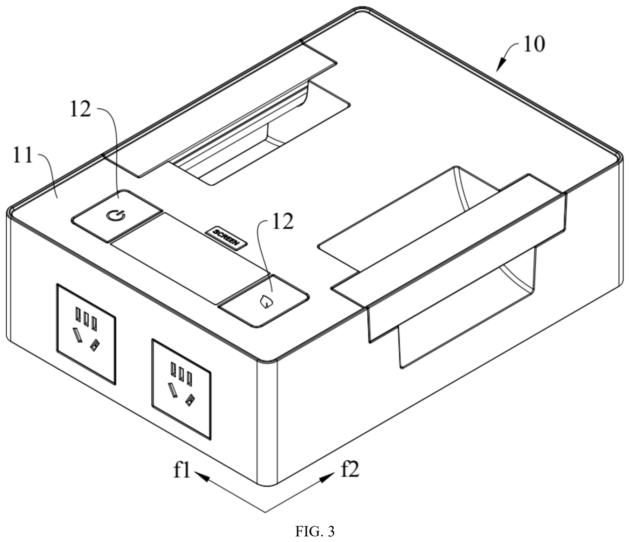

Referring to FIG. 3 to FIG. 5, in the present disclosure, the first housing 11 defines a button via hole 111 communicating the interior of the first housing 11 with the exterior of the first housing 11. That is, the button via hole 111 extends through the inner surface of the first housing 11 and the outer surface of the first housing 11. In addition, the first housing 11 is provided with a first fixing portion 112 on an inner surface of the first housing 11.

In the present disclosure, the button structure 12 includes a button body 121 and a resilient arm 122. The button body 121 passes through the button via hole 111. The button body 121 is provided with a button protrusion 1211 protruding towards the interior of the first housing 11. The resilient arm 122 is positioned inside the first housing 11. The resilient arm 122 has a connecting end 1221 and a fixing end 1222 opposite to the connecting end 1221 in an extension direction of the resilient arm 122. The connecting end 1221 is connected to the button body 121. The fixing end 1222 is connected to the first fixing portion 112. Therefore, the fixed connection between the button structure 12 and the first housing 11 can be implemented.

The "fixed connection" herein refers to that the fixing end 1222 is not moveable relative to the first housing 11 after the fixing end 1222 is connected to the first housing 11, and includes detachable connections such as threaded connection, snap-fit connection, insertion connection, pin connection, and magnetic attraction connection, as well as non-detachable connections such as welding, adhesion, and riveting. It can be understood that, apart from the "fixed connection" mentioned herein referring to that, the fixing end 1222 is not movable relative to the first housing 11 after the fixing end 1222 is connected to the first housing 11, and includes both detachable and non-detachable connections, the subsequently mentioned "fixed connection" also refers to that, the fixing end 1222 is not movable relative to the first housing 11 after the fixing end 1222 is connected to the first housing 11, and also includes both detachable and non-detachable connections. That is, the term "fixed connection" mentioned in the present disclosure refers to that, after two components are connected, one component is not movable relative to the other component, and includes detachable and non-detachable connections.

In the present disclosure, the circuit board 13 is disposed inside the first housing 11, and is positioned at one side of the button structure 12 positioned facing away from the button via hole 111. The circuit board 13 is electrically connected to the energy storage unit. The circuit board 13 is provided with a control button 131 protruding from a surface of the circuit board 13 positioned facing towards the button structure 12. In addition, one of the circuit board 13 and the fixing end 1222 is provided with a positioning portion 132, and the other of the circuit board 13 and the fixing end 1222 is provided with a fitting portion 1223. That is, when the circuit board 13 is provided with the positioning portion 132, the fixing end 1222 is provided with the fitting portion 1223; and when the circuit board 13 is provided with the fitting portion 1223, the fixing end 1222 is provided with the positioning portion 132. The fitting portion 1223 is in fit connection with the positioning portion 132, so that the control button 131 on the circuit board 13 is positioned at a position corresponding to the button protrusion 1211 on the button body 121. That is so say, during actual assembly, by means of the fitting between the fitting portion 1223 and the positioning portion 132, the button structure 12 and the circuit board 13 can be precisely positioned, so as to ensure the accurate positioning between the button structure 12 and the circuit board 13. Therefore, it is ensured that the button protrusion 1211 on the button structure 12 can be aligned with the control button 131 on the circuit board 13, so that the button structure 12 is prevented from malfunction, so as to ensure the control effect of the button structure 12.

In one exemplary embodiment, the positioning portion 132 may be a positioning hole, the fitting portion 1223 may be a positioning protrusion in fit with the positioning hole, and the positioning protrusion is inserted into the positioning hole.

In another exemplary embodiment, the positioning portion 132 may be a positioning protrusion, the fitting portion 1223 may be a positioning hole in fit with the positioning protrusion, and the positioning protrusion is inserted into the positioning hole.

In yet another exemplary embodiment, both the positioning portion 132 and the fitting portion 1223 may be positioning holes, and the positioning portion 132 and the fitting portion 1223 may be brought into fit connection by means of a positioning pin such as a screw or a bolt, so that the positioning portion 132 and the fitting portion 1223 can implement a positioning function.

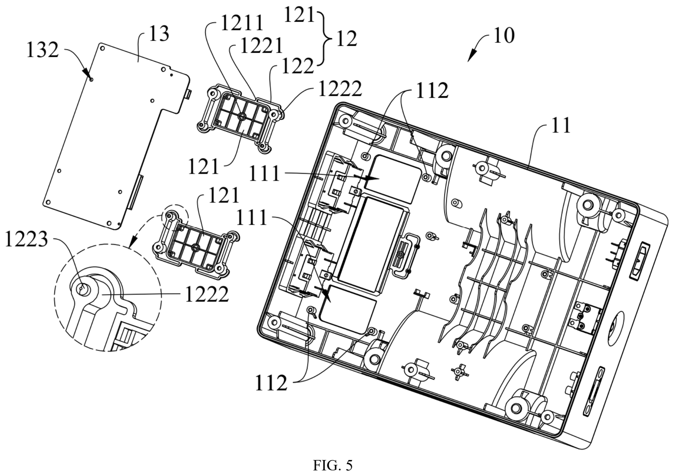

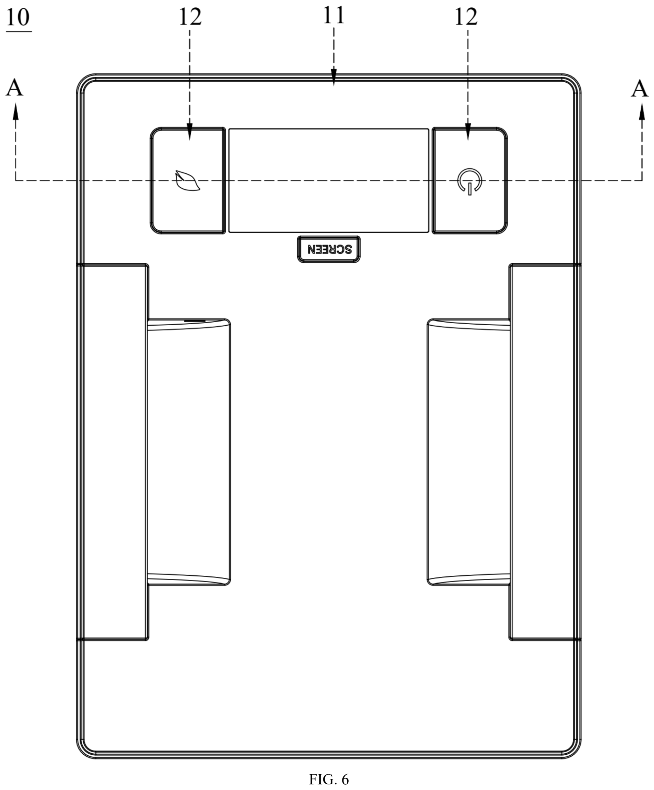

In some optional embodiments, as illustrated in FIG. 5, FIG. 6, and FIG. 7, the circuit board 13 provided in an embodiment of the present disclosure abuts against the fixing end 1222 in the depth direction of the button via hole 111, so that the fixing end 1222 cannot only provide an arrangement position for the positioning structure (i.e., the aforementioned fitting portion 1223 and the positioning portion 132) of the circuit board 13, so as to serve as a positioning site for the circuit board 13, but also provide a supporting force for the circuit board 13, thereby preventing the circuit board 13 from being squeezed or even experiencing circuit failure, and improving the stability of the whole structure.

It may be understood that, when the button body 121 in the present disclosure is not pressed, the button protrusion 1211 may be spaced apart from or in contact with the control button 131. When the button body 121 is pressed, the button body 121 moves relative to the button via hole 111, and simultaneously drives the button protrusion 1211 to move to press the control button 131 on the circuit board 13, so as to trigger the circuit board 13 to perform corresponding operation control, thereby controlling the mobile energy storage apparatus to implement corresponding functions, for example, controlling the mobile energy storage apparatus to implement power on-off, charging and discharging, and other functions.

In this pressing process, since the fixing end 1222 of the resilient arm 122 is fixed by the first housing 11, and the connecting end 1221 of the resilient arm 122 is connected to the button body 121, the resilient arm 122 is pulled and deformed when the button body 121 is pressed, and the resilient arm 122 restores deformation and drives the button body 121 to reset when the button body 121 is no longer pressed.

However, the inventors have found in actual operation that, in the related art, in the pressing process of the button structure 12, especially when the button structure 12 is pressed at the edge positions of the button structure 12, it is prone to a phenomenon where one side of the button structure 12 sinks significantly while the other side of the button structure 12 sinks only slightly, thereby causing deflection. As a result, the button protrusion 1211 on the button structure 12 and the control button 131 on the circuit board 13 become deviated and misaligned, leading to malfunction or weak touch feeling of the button structure 12, and consequently resulting in poor user experience.

Based on this, referring to FIG. 5, FIG. 8, and FIG. 9, the button structure 12 provided in an embodiment of the present disclosure includes multiple resilient arms 122 arranged at intervals in the circumferential direction of a button body 121. There are multiple first fixing portions 112. The multiple first fixing portions 112 are respectively connected to fixing ends 1222 of the multiple resilient arms 122. In this way, the button body 121 can be connected to the first housing 11 through the multiple resilient arms 122, so that the force applied to the button body 121 when being pressed can be more dispersed and even, thereby avoiding a situation in which the pressing failure occurs due to the uneven force applied to the button structure 12 in the pressing process. Thus, the accuracy of the pressing of the button structure 12 is ensured, the button structure 12 is prevented from malfunction to not affect the function of the mobile energy storage apparatus, and the use experience of the user is improved.

In the present disclosure, the number (that is, quantity) of the resilient arms 122 may be two, three, four, five, six, seven, eight, or the like. When the number of the resilient arms 122 is two, four, six, eight, ten, etc., and so on, the number of the resilient arms 122 is an even number. When the number of the moment arm 122 is three, five, seven, nine, etc., and so on, the number of the moment arm 122 is an odd number.

In some optional embodiments, regardless of whether the number of the resilient arms 122 is an odd number or an even number, the fixing ends 1222 of any two adjacent resilient arms 122 are connected through the connecting rib 123. In this way, any two adjacent resilient arms 122 can form a square-shaped structure together with the button body 121, and the structure can be more stable, thereby improving the overall structural stability of the button structure 12, and further effectively preventing the problem of button malfunction caused by the deviation of the button structure 12 in the pressing process.

When the number of the resilient arms 122 is an even number, the fixing ends 1222 of the resilient arms 122 are connected in pairs through the connecting rib 123, that is, the fixing ends 1222 of the two resilient arms 122 connected through the connecting rib 123 are not connected to fixing ends 1222 of adjacent resilient arms 122 through the connecting rib 123. In other words, not every two resilient arms 122 has their respective fixing ends 1222 connected to each other through the connecting rib 123, and each resilient arm 122 has a fixing end 1222 only connected to one connecting rib 123.

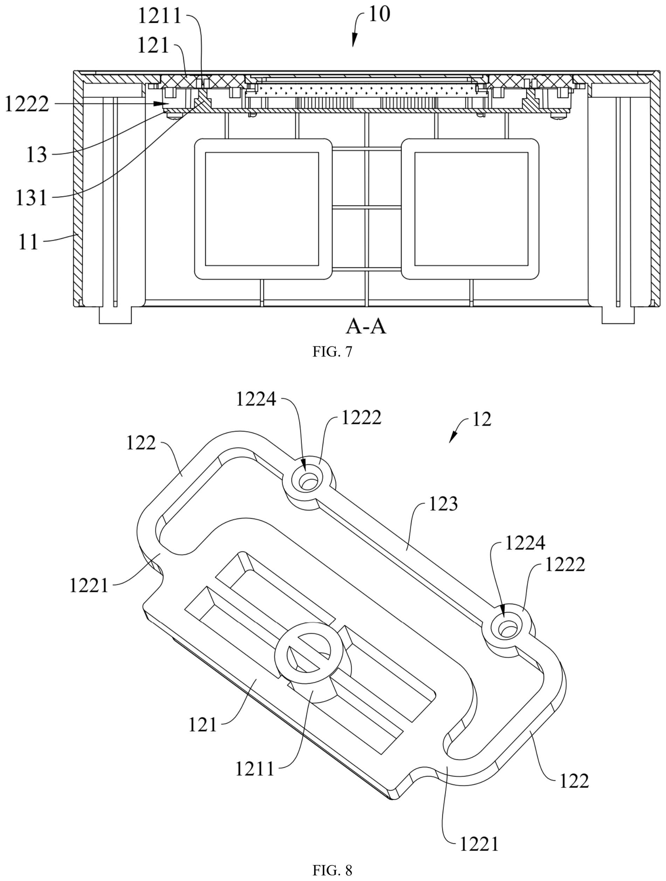

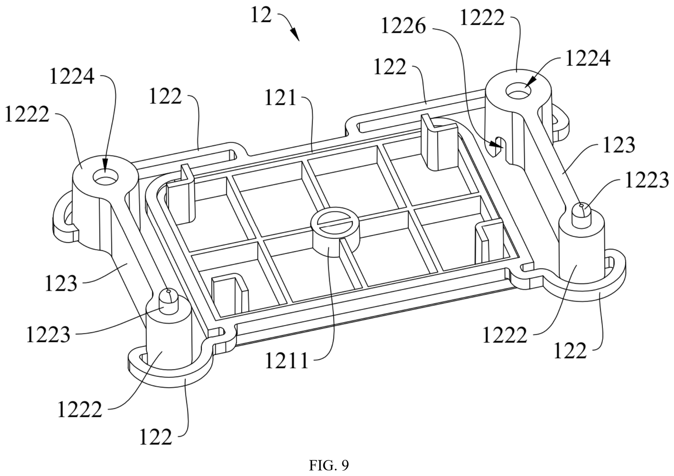

In one exemplary embodiment, as illustrated in FIG. 8, the button structure 12 includes two resilient arms 122. The fixing ends 1222 of the two resilient arms 122 are connected through the connecting rib 123. In another exemplary embodiment, as illustrated in FIG. 9, the button structure 12 includes four resilient arms 122, in which fixing ends 1222 of two resilient arms 122 are connected through one connecting rib 123, and fixing ends 1222 of the other two resilient arms 122 are connected through the other connecting rib 123.

In this design, although it is impossible for any two adjacent resilient arms to form one square-shaped structure together with the button body 121, each resilient arm 122 and another resilient arm 122 can form one square-shaped structure together with the button body 121, so that no resilient arm is left alone or independent and excluded from being part of the square-shaped structure. Likewise the overall structure of the button structure 12 can be relatively stable, so as to prevent the problem of button malfunction caused by the deviation of the button structure 12 in the pressing process.

In the present disclosure, the number of the first fixing portions 112 may be equal to or unequal to the number of the resilient arms 122.

When the number of the first fixing portions 112 is unequal to the number of the resilient arms 122, the number of the first fixing portions 112 is less than the number of the resilient arms 122. In addition, for two resilient arms 122 connected to each other through the connecting rib 123, a fixing end 1222 of one of the two resilient arms 122 is connected to the first fixing portion 112, and a fixing end 1222 of the other of the two resilient arms 122 is not connected to the first housing 11 through the first fixing portion 112, that is, the first housing 11 is not provided with a first fixing portion 112 connected to the other resilient arm 122, and the fixing end 1222 of the other resilient arm 122 is provided with a fitting portion 1223 or a positioning portion 132. In this way, the two resilient arms 122 connected through the connecting rib 123 may be connected to the first housing 11 by means of one of the two resilient arms 122 connected to the first fixing portion 112. Thus, even if the other of the two resilient arms 122 is not fixed and connected to the first housing 11 through the first fixing portion 112, deformation of the other of the two resilient arms 122 when the button body is pressed is not affected. That is, when the button body 121 is pressed, the other of the two resilient arms 122 not fixed and connected to the first housing 11 can still be deformed, thereby distributing the force applied to the button body 121. Meanwhile, since the positioning portion 132 or the fitting portion 1223 is disposed at the fixing end 1222 that is not connected to the first casing 11, that is, the positioning portion 132 or the fitting portion 1223 is not disposed at the fixing end 1222 that is connected to the first fixing portion 112, the fixing end 1222 can have a sufficient space to be connected to the first fixing portion 112. Therefore, the interference of the positioning portion 132 or the fitting portion 1223 on the fixed connection between the fixing end 1222 and the first fixing portion 112 is avoided, so that the connection reliability between the fixing end 1222 and the first fixing portion 112 is ensured.

In some optional embodiments, the circuit board 13 may be directly fixed and connected to the first housing 11. In other optional embodiments, the circuit board 13 may be indirectly fixed and connected to the first housing 11 through the button structure 12, for example, may be indirectly fixed and connected to the first housing 11 through the fixing end 1222.

The following provides a further detailed description of the technical solution of the present disclosure by taking, as an example, the circuit board 13 being indirectly fixed and connected to the first housing 11 through the fixing end 1222.

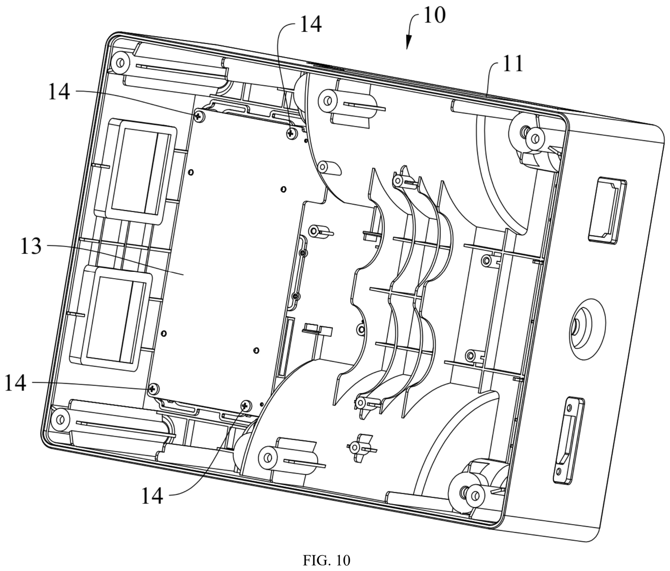

Referring to what are illustrated in FIG. 9, FIG. 10, and FIG. 11, the circuit board 13 provided in an embodiment of the present disclosure is provided with a second fixing portion 133, and the second fixing portion 133 is connected to the fixing end 1222, to make the circuit board 13 fixed and connected to the inside of the first housing 11. Since the button structure 12 is positioned between the circuit board 13 and the inner surface of the first housing 11, if the circuit board 13 is directly connected to the inner surface of the first housing 11, in order to avoid being blocked by the button structure 12, the area of the circuit board 13 is usually increased so as to reserve a position on the circuit board 13 staggered with the button structure 12 as a position for connection with the first housing 11. That is, the circuit board 13 has a connection position beyond the periphery of the button structure 12 and is not blocked by the button structure 12. However, in this way, it is easy to increase the occupation of the space of the first housing 11 by the circuit board 13, which is not conducive to miniaturized design. Therefore, by connecting the second fixing portion 133 and the fixing end 1222, the circuit board 13 can be fixed and connected to the first housing 11, and the area of the circuit board 13 does not need to be increased additionally, which facilitates a miniaturized design of the circuit board 13 and reduces occupation of an internal space of the first housing 11 by the circuit board 13. Thus, the miniaturized design of the housing assembly 10 is implemented, so that the housing assembly 10 can be applicable to a mobile energy storage apparatus of a miniaturized design, thereby facilitating the user to carry the mobile energy storage apparatus by hand.

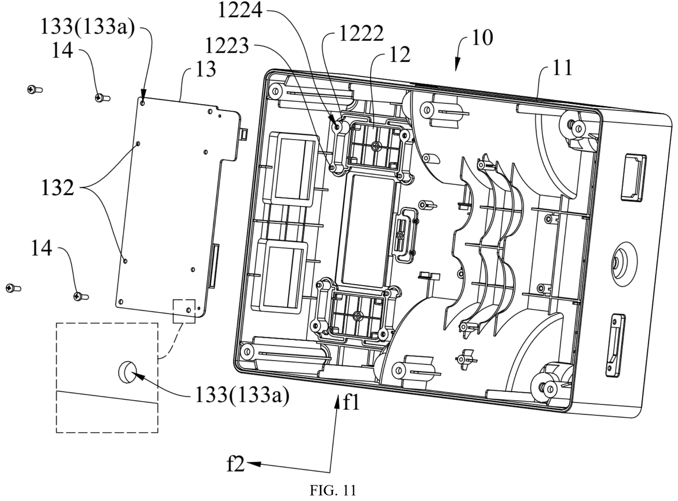

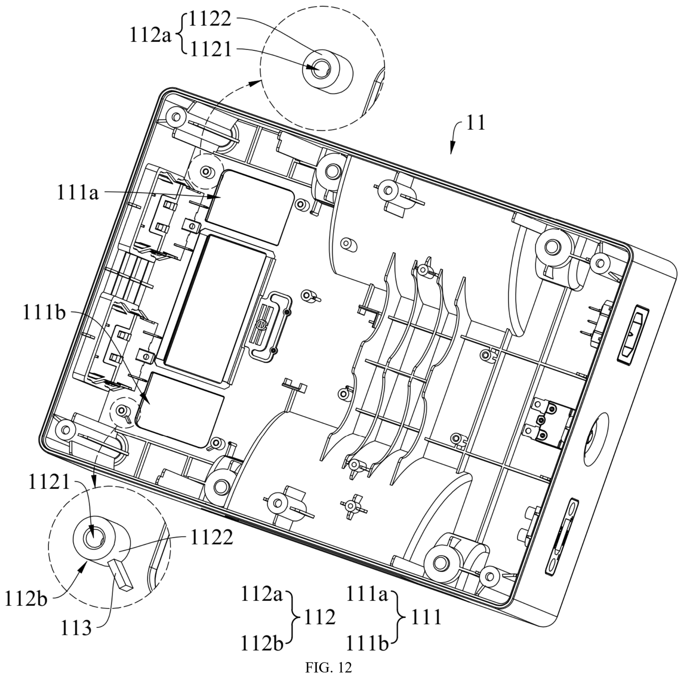

In some optional embodiments, as illustrated in FIG. 11 and FIG. 12, the first fixing portion 112 includes a first threaded hole 1121 defined on the inner surface of the first housing 11. The fixing end 1222 defines a first through hole 1224 extending through the fixing end 1222 in the axial direction of the first threaded hole 1121. The first through hole 1224 is in communication with the first threaded hole 1121. The second fixing portion 133 includes a second through hole 133a defined on the circuit board 13. The second through hole 133a is communicated with the first through hole 1224. The housing assembly 10 further includes a first threaded member 14. For example, the first threaded member 14 may be a screw or a bolt. The first threaded member 14 passes through the second through hole 133a and the first through hole 1224 in sequence from the surface of the circuit board 13 positioned facing away from the button structure 12, and is screwed into the first threaded hole 1121, thereby realizing the fastening connection of the circuit board 13, the fixing end 1222, and the first housing 11. In this way, the fixed connection between the circuit board 13 and the fixing end 1222 can share the same threaded member, which not only saves the use of components and reduces costs, but also allows the locking of the circuit board 13 and the fixing end 1222 to be completed in one operation, without separately locking the circuit board 13 and the fixing end 1222, thereby simplifying the assembly operations of the housing assembly 10, and thus being conducive to improving the assembly efficiency of the housing assembly 10.

In some optional embodiments, as illustrated in FIG. 11 to FIG. 13, the first fixing portion 112 further includes a threaded seat 1122 protruding from the inner surface of the first housing 11. A surface of the threaded seat 1122 positioned facing towards the circuit board 13 is recessed to define the first threaded hole 1121. That is, the first fixing portion 112 includes the threaded seat 1122 and the first threaded hole 1121 defined on the threaded seat 1122. A surface of the fixing end 1222 of the resilient arm 122 positioned facing away from the circuit board 13 is recessed to define a positioning recess 1225, that is, the fixing end 1222 is recessed inwards towards the surface of the first housing 11 to form a positioning recess 1225, and the threaded seat 1122 is embedded in the positioning recess 1225. The first through hole 1224 is formed on the bottom surface of the slot of the positioning recess 1225, so that the first threaded member 14 can penetrate through the second through hole 133a and the first through hole 1224 in sequence from the surface of the circuit board 13 away from the button structure 12, and is screwed into the first threaded hole 1121, thereby implementing the fastening connection among the circuit board 13, the fixing end 1222, and the first housing 11.

By means of the described design method, during actual assembly, the fitting of the threaded seat 1122 and the positioning recess 1225 can be used to quickly and precisely assemble the button structure 12 to the first housing 11 at a preset mounting position, so that during alignment of the button body 121 with the button via hole 111 and passing through the button via hole 111, the occurrence of deviation is avoided, thereby improving the mounting precision and assembly efficiency of the button structure 12. In addition, the threaded seat 1122 may be configured to define the first threaded hole 1121, so as to provide a locked position for fixing the circuit board 13 and the fixing end 1222, and may also be in fit with the positioning recess 1225 on the fixing end 1222, so as to provide a positioning effect for assembly of the button structure 12. In this way, the threaded seat 1122 can be used in a dual-purpose manner without additionally arranging the positioning protrusion to be in fit with the positioning recess 1225 so as to achieve the positioning effect. Thus, the structure design of the first housing 11 can be simplified, the first housing 11 can be formed through manufacturing conveniently, and the manufacturing cost of the first housing 11 can be reduced.

In addition, by providing the threaded seat 1122 protruding from the inner surface of the first housing 11, and by defining the first threaded hole 1121 on the threaded seat 1122, the first housing 11 can be designed to maintain a relatively thin wall thickness so as to achieve a light-weight design, thereby achieving a light-weight design of the mobile energy storage apparatus, and facilitating the user to carry the mobile energy storage apparatus by hand. Meanwhile, the depth of the first threaded hole 1121 is lengthened due to the threaded seat 1122 so as to increase the connection area between the first threaded hole 1121 and the first threaded member 14, thereby improving the connection reliability between the first threaded hole 1121 and the first threaded member 14, and improving the mounting reliability of the button structure 12 and the circuit board 13 in the first housing 11. Meanwhile, the fact that the first threaded hole 1121 extends through the outer surface of the first housing 11 since the depth of the first threaded hole 1121 needs to be lengthened can be avoided, so that the outer surface of the first housing 11 exposed in the external environment is free from pores, thereby preventing liquids such as rain water from entering the interior of the first housing 11 from the pores, and improving the water resistant performance of the housing assembly 10.

In the present disclosure, the housing assembly 10 mainly serves as a top cover of the mobile energy storage apparatus. The button structure 12 on the housing assembly 10 is mainly configured to control the power on-off and charging and discharging of the mobile energy storage apparatus. Certainly, in other embodiments, when the mobile energy storage apparatus includes a display screen and an indicator light, for example, both the display screen and the indicator light may be disposed on the first housing 11, the button structure 12 on the housing assembly 10 may be further configured to control illumination, display, and the like of the mobile energy storage apparatus.

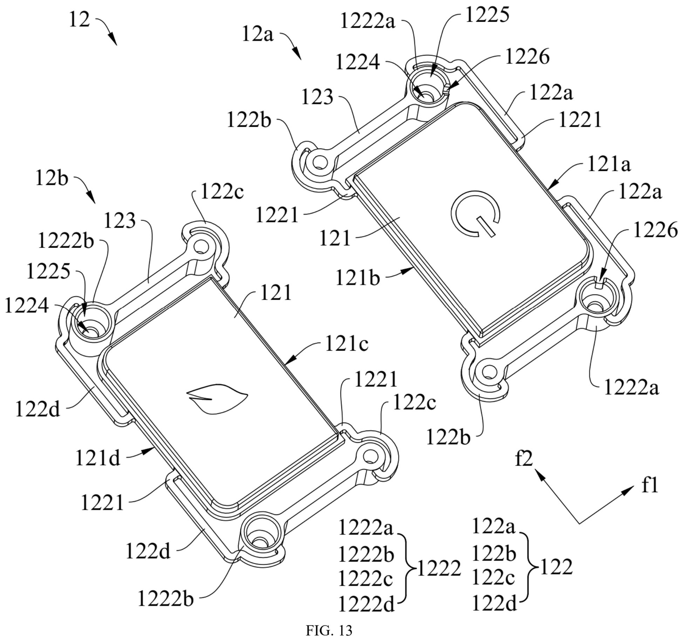

Based on this, in the present disclosure, in order to achieve different functions by pressing different buttons, referring to FIG. 13, the button structure 12 provided in the embodiment of the present disclosure may include a first sub-button 12a and a second sub-button 12b. The first sub-button 12a and the second sub-button 12b have different functions, that is, the first sub-button 12a and the second sub-button 12b have different uses, so that the first sub-button 12a can be pressed to control the mobile energy storage apparatus to achieve one function, and the second sub-button 12b can be pressed to control the mobile energy storage apparatus to achieve another function.

Exemplarily, the first sub-button 12a can serve as a whole switch button of the mobile energy storage apparatus, so that switch-on and switch-off of the mobile energy storage apparatus may be controlled by pressing the first sub-button 12a. The second sub-button 12b can serve as a direct current output switch button (i.e., a DC output switch button) and/or an alternating current output switch button (i.e., an AC output switch button) of the mobile energy storage apparatus, and the mobile energy storage apparatus can be controlled to output a DC and/or an AC by pressing the second sub-button 12b. Specifically, when an external power plug is plugged into a power socket for outputting a DC, the mobile energy storage apparatus can be controlled to output a DC by pressing the second sub-button 12b. When the external power plug is plugged into a power socket for outputting an AC, the mobile energy storage apparatus can be controlled to output an AC by pressing the second sub-button 12b. When the external power plug is plugged into both the power socket for outputting the DC and the power socket for outputting the AC, the mobile energy storage apparatus can be controlled to not only output the DC but also output the AC by pressing the second sub-button 12b.

In addition, in the present disclosure, in order to facilitate the user to distinguish functions of different buttons (i.e., the first sub-button 12a and the second sub-button 12b), an identifier corresponding to the function thereof, such as, but not limited to, a printing identifier, a protrusion identifier, a recess identifier, and a fluorescent identifier, is generally provided on a surface of the button exposed beyond the first housing 11.

In the present disclosure, as illustrated in FIG. 12 and FIG. 13, each of the first sub-button 12a and the second sub-button 12b includes a button body 121 and a resilient arm 122. Correspondingly, the button via hole 111 includes a first sub via hole 111a and a second sub via hole 111b. The first fixing portion 112 includes a first fixing sub-portion 112a and a second fixing sub-portion 112b. The button body 121 of the first sub-button 12a passes through the first sub via hole 111a, and the fixing end 1222 of the resilient arm 122 of the first sub-button 12a is connected to the first fixing sub-portion 112a, so that the first sub-button 12a is fixed and connected to the first housing 11. The button body 121 of the second sub-button 12b passes through the second sub via hole 111b, and the fixing end 1222 of the resilient arm 122 of the second sub-button 12b is connected to the second fixing sub-portion 112b, so that the second sub-button 12b is fixed and connected to the first housing 11.

For ease of description, in the present disclosure, the fixing end 1222 of the first sub-button 12a is configured as a first fixing end 1222a, and the fixing end 1222 of the second sub-button 12b is configured as a second fixing end 1222b. At least one of the first fixing end 1222a or the second fixing end 1222b is provided with a first foolproof portion 1226. The first housing 11 is provided with a second foolproof portion 113 on the inner surface of the first housing 11. One of the first foolproof portion 1226 and the second foolproof portion 113 is a foolproof protrusion, and the other of the first foolproof portion 1226 and the second foolproof portion 113 is a foolproof slot. That is, when the first foolproof portion 1226 is the foolproof protrusion, the second foolproof portion 113 is the foolproof slot; when the first foolproof portion 1226 is the foolproof slot, the second foolproof portion 113 is the foolproof protrusion; and the foolproof protrusion is embedded in the foolproof slot. In this way, by means of the fitting between the foolproof protrusion and the foolproof slot, an effective foolproof function is provided for the assembly of the first sub-button 12a and the second sub-button 12b, thereby preventing the first sub-button 12a from being assembled into the second sub via hole 111b in the assembly process, and preventing the second sub-button 12b from being assembled into the first sub via hole 111a. Therefore, assembly errors of the first sub-button 12a and the second sub-button 12b can be avoided, thereby effectively preventing a situation in which a preset function is not matched and errors occur when a target button is pressed, so as to ensure the control accuracy of the first sub-button 12a and the second sub-button 12b.

For example, assuming that the first sub-button 12a serves as a whole switch button of the mobile energy storage apparatus and the second sub-button 12b serves as a DC output switch button of the mobile energy storage apparatus, and assuming that the first sub-button 12a and the second sub-button 12b are mounted backwards, if the user wants to start the mobile energy storage apparatus, the user may press the first sub-button 12a, but since the first sub-button 12a and the second sub-button 12b are mounted backwards, it is impossible control the mobile energy storage apparatus to start to start to power on by pressing the first sub-button 12a, thereby affecting use. In contrast, in the present disclosure, by means of the arrangement of the foolproof protrusion and the foolproof slot and the fitting between the foolproof protrusion and the foolproof slot, and the foolproof mounting is achieved in the assembly process, so that the assembly error of the first sub-button 12a and the second sub-button 12b can be effectively prevented, and the function accuracy of the first sub-button 12a and the second sub-button 12b can be ensured.

The following provides a further detailed description of the technical solution of the present disclosure by taking, as an example, the first foolproof portion 1226 is the foolproof slot and the second foolproof portion 113 is the foolproof protrusion.

As an optional implementation, each of the first fixing end 1222a and the second fixing end 1222b is provided with a first foolproof portion 1226, and the first foolproof portion 1226 on the first fixing end 1222a and the first foolproof portion 1226 on the second fixing end 1222b have different shapes. At this time, the shape of the second foolproof portion 113 in fit with the first foolproof portion 1226 on the first fixing end 1222a is the same as the shape of the first foolproof portion 1226 on the first fixing end 1222a, and the shape of the second foolproof portion 113 in fit with the first foolproof portion 1226 on the second fixing end 1222b is the same as the shape of the first foolproof portion 1226 on the second fixing end 1222b.

Specifically, when the first foolproof portion 1226 on the first fixing end 1222a and the first foolproof portion 1226 on the second fixing end 1222b have different shapes, for example, when the first foolproof portion 1226 on the first fixing end 1222a is circular in shape, and the first foolproof portion 1226 on the second fixing end 1222b is rectangular in shape, in the assembly process, only when the first foolproof portion 1226 and the second foolproof portion 113 have the same shape, the first foolproof portion 1226 can be fitted and mounted with the second foolproof portion 113. At this time, both the first fixing end 1222a and the second fixing end 1222b are not blocked by the foolproof protrusion, so that the button body 121 of the first sub-button 12a and the button body 121 of the second sub-button 12b can be smoothly mounted into the corresponding button via holes 111 to be mounted on the first housing 11. In this way, the first foolproof portion 1226 and the second foolproof portion 113 in different shapes cannot be mounted, thereby preventing the first sub-button 12a and the second sub-button 12b from being installed backwards, and achieving the foolproof mounting effect for the button structure 12.

However, the design in the present disclosure is not limited thereto. In some other optional embodiments, the sizes of the first foolproof portions 1226 of the first sub-button 12a and the second sub-button 12b may also be set to be different, or positions at which the first foolproof portions 1226 of the first sub-button 12a and the second sub-button 12b are provided may also be set to be different, which may also achieve the foolproof mounting effect of the button structure 12. It may be noted that, in other further embodiments of the present disclosure, the first foolproof portions 1226 of the first sub-button 12a and the second sub-button 12b may have at least two features that are different in shape, size, and position, so as to achieve the foolproof mounting effect of the button structure 12.

As another optional implementation, as illustrated in FIG. 13, only one of the first fixing end 1222a and the second fixing end 1222b is provided with the first foolproof portion 1226. That is, when the first fixing end 1222a is provided with the first foolproof portion 1226, the second fixing end 1222b is not provided with the first foolproof portion 1226, and when the first fixing end 1222a is not provided with the first foolproof portion 1226, the second fixing end 1222b is provided with the first foolproof portion 1226. In this way, in the assembly process, when the first sub-button 12a and the second sub-button 12b are mounted in reverse, the foolproof protrusion may be blocked by a surface without the foolproof slot, so that the first sub-button 12a or the second sub-button 12b cannot be mounted, thereby prompting the mounting personnel that the first sub-button 12a and the second sub-button 12b are mounted backwards, and achieving the foolproof mounting effect for the button structure 12. Furthermore, the fitting between the foolproof protrusion and the foolproof slot not only provides the foolproof function but also provides a positioning function.

In the present disclosure, when the first fixing portion 112 is a protrusion protruding from the inner surface of the first housing 11, that is, as described above, when the first fixing portion 112 includes the threaded seat 1122 and the first threaded hole 1121 defined on the threaded seat 1122, the surface of each of the first fixing end 1222a and the second fixing end 1222b positioned facing away from the circuit board 13 is recessed to define the positioning recess 1225, and the first fixing portion 112 is embedded in the positioning recess 1225.

The second foolproof portion 113 is the foolproof protrusion, and the second foolproof portion 113, that is, the foolproof protrusion, is connected to an outer peripheral surface of the first fixing portion 112. The first foolproof portion 1226 is the foolproof slot in communication with the positioning recess 1225, and the first foolproof portion 1226, that is, the foolproof slot extends through the surface of the first fixing end 1222a and/or the second fixing end 1222b positioned facing away from the circuit board 13, and the second foolproof portion 113 is embedded in the first foolproof portion 1226. Specifically, when the first foolproof portion 1226 is the foolproof slot defined on the first fixing end 1222a, the foolproof slot is in communication with the positioning recess 1225, and extends through the surface of the first fixing end 1222a positioned facing away from the circuit board 13 to define a notch, so as to ensure that the foolproof protrusion can be inserted into the foolproof slot from the notch. When the second foolproof portion 113 is the foolproof slot defined on the second fixing end 1222b, the foolproof slot is in communication with the positioning recess 1225, and extends through the surface of the second fixing end 1222b positioned facing away from the circuit board 13 to define a notch, so as to ensure that the foolproof protrusion can be inserted into the foolproof slot from the notch. When each of the first fixing end 1222a and the second fixing end 1222b defines the foolproof slot, the foolproof slot on the first fixing end 1222a is in communication with the positioning recess 1225 on the first fixing end 1222a and extends through the surface of the first fixing end 1222a positioned facing away from the circuit board 13, and the foolproof slot on the second fixing end 1222b is in communication with the positioning recess 1225 on the second fixing end 1222b and extends through the surface of the second fixing end 1222b positioned facing away from the circuit board 13.

By adopting the described design mode, the first sub-button 12a and the second sub-button 12b can be prevented from being mounted backwards by means of the fitting between the foolproof protrusion and the foolproof slot, and the foolproof guide function is provided for the mounting of the first sub-button 12a and the second sub-button 12b, thereby improving the mounting precision of the first sub-button 12a and the second sub-button 12b. In addition, the foolproof protrusion can be in fit with the foolproof slot to achieve the foolproof mounting effect, and can also serve as a reinforcing rib of the first fixing portion 112 to reinforce structural strength of the first fixing portion 112, thereby improving connection reliability of the button structure 12 and the circuit board 13 on the first housing 11.

Referring to FIG. 11 to FIG. 13, the circuit board 13 has a first preset direction f1 and a second preset direction f2 that are defined at an angle (e.g., 90°), and the size of the circuit board 13 in the first preset direction f1 is larger than or equal to the size of the circuit board 13 in the second preset direction f2. Exemplarily, when the circuit board 13 may have a rectangular plate structure, the first preset direction f1 may be a length direction of the circuit board 13, and the second preset direction f2 may be a width direction of the circuit board 13. In addition, the circuit board 13 is connected to the first housing 11 at two ends of the circuit board 13 in the first preset direction f1.

In the present disclosure, the first sub-button 12a and the second sub-button 12b are spaced apart from each other on two sides of the circuit board 13 in the first preset direction f1 of the circuit board 13. The button body 121 of the first sub-button 12a has a first side 121a and a second side 121b opposite to the first side 121a in the first preset direction f1, and the second side 121b is closer to the second sub-button 12b than the first side 121a. The button body 121 of the second sub-button 12b has a third side 121c and a fourth side 121d opposite to the third side 121c in the first preset direction f1, and the third side 121c is closer to the first sub-button 12a than the fourth side 121d. That is, the second side 121b and the third side 121c are positioned between the first side 121a and the fourth side 121d.

In addition, in the present disclosure, the multiple resilient arms 122 in the first sub-button 12a include a first resilient sub-arm 122a and a second resilient sub-arm 122b. The first resilient sub-arm 122a is disposed at the first side 121a, and the connection end 1221 of the first resilient sub-arm 122a is connected to a side surface, which is positioned facing away from the second sub-button 12b, of the button body 121 of the first sub-button 12a at the first side 121a. The second resilient sub-arm 122b is disposed at the second side 121b, and the connection end 1221 of the second resilient sub-arm 122b is connected to a side surface, which is positioned facing towards the second sub-button 12b, of the button body 121 of the first sub-button 12a at the second side 121b. The multiple resilient arms 122 of the second sub-button 12b include a third resilient sub-arm 122c and a fourth resilient sub-arm 122d. The third resilient sub-arm 122c is disposed at the third side 121c, and the connection end 1221 of the third resilient sub-arm 122c is connected to a side surface, which is positioned facing towards the first sub-button 12a, of the button body 121 of the second sub-button 12b at the third side 121c. The fourth resilient sub-arm 122d is disposed at the fourth side 121d, and the connection end 1221 of the fourth resilient sub-arm 122d is connected to a side surface, which is positioned facing away from the first sub-button 12a, of the button body 121 of the second sub-button 12b at the fourth side 121d.

In the present disclosure, the length of the first resilient sub-arm 122a in the extension direction of the first resilient sub-arm 122a is larger than the length of the second resilient sub-arm 122b in the extension direction of the second resilient sub-arm 122b, and/or the length of the fourth resilient sub-arm 122d in the extension direction of the fourth resilient sub-arm 122d is larger than the length of the third resilient sub-arm 122c in the extension direction of the third resilient sub-arm 122c.

Since the size of the circuit board 13 in the first preset direction f1 is larger than or equal to the size of the circuit board 13 in the second preset direction f2, only two ends of the circuit board 13 in the first preset direction is fixed and connected to the first housing 11, and there is no connecting portion or supporting portion at the middle position of the circuit board 13 in the first preset direction f1. Meanwhile, according to mechanical principles, when the resilient arm 122 is longer, the moment is greater. Thus, since the length of the first resilient sub-arm 122a in the extension direction of the first resilient sub-arm 122a is larger than the length of the second resilient sub-arm 122b in the extension direction of the second resilient sub-arm 122b, the first resilient sub-arm 122a can be more easily subjected to a force and is more deformed than the second resilient sub-arm 122b, so that in the process of the user pressing the first sub-button 12a, the overall stress can be distributed more on the first resilient sub-arm 122a. Considering that the first resilient sub-arm 122a is close to one end of the circuit board 13 in the first preset direction f1, one end of the circuit board 13 in the first preset direction f1 can be first subjected to the force, that is, one end of the circuit board 13 connected and fixed to the first housing is first subjected to the force. In this way, the circuit board 13 is prevented from being subjected to a force first at a position which is deviated from the center and lacks connection and support in the preset direction f1, thereby reducing the risk of deformation or even fracture of the circuit board 13 can be reduced.

Similarly, since the length of the fourth resilient sub-arm 122d in the extension direction of the fourth resilient sub-arm 122d is larger than the length of the third resilient sub-arm 122c in the extension direction of the third resilient sub-arm 122c, the fourth resilient sub-arm 122d is more easily subjected to a force and is more deformed than the third resilient sub-arm 122, so that in the process of the user pressing the second sub-button 12b, the overall stress can be distributed more on the fourth resilient sub-arm 122d. Considering that the fourth resilient sub-arm 122d is close to the other end of the circuit board 13 in the first preset direction f1, the other end of the circuit board 13 in the first preset direction f1 can be first subjected to the force, that is, the other end of the circuit board 13 connected and fixed to the first housing is first subjected to the force. In this way, the circuit board 13 is prevented from being subjected to the force first at a position which is deviated from the center and lacks connection and support in the first preset direction f1, thereby reducing the risk of deformation or even fracture of the circuit board 13.

In some optional embodiments, the first resilient sub-arm 122a and the second resilient sub-arm 122b are symmetrically disposed. The third resilient sub-arm 122c and the fourth resilient sub-arm 122d are symmetrically disposed. In this way, the button structure 12 can be subjected to the force more evenly at two sides of the circuit board 13 in the first preset direction respectively, thereby avoiding the problem of button malfunction caused by the deviation of the button structure 12 in the pressing process.

Referring to what are illustrated in FIG. 11, FIG. 12, and FIG. 14, in the present disclosure, the first resilient sub-arm 122a is connected to the second resilient sub-arm 122b through a connecting rib 123. A fixing end 1222 of the first resilient sub-arm 122a is connected to the first fixing portion 112. A fixing end 1222 of the second resilient sub-arm 122b is not connected to the first housing 11 through a first fixing portion 112, that is, the first housing 11 is not provided with the first fixing portion 112 connected to the second resilient sub-arm 122b. The fixing end 1222 of the first resilient sub-arm 122a is connected to one end of the circuit board 13 in the first preset direction f1. The fixing end 1222 of the second resilient sub-arm 122b is provided with the positioning portion 132 or the fitting portion 1223. In this way, the second resilient sub-arm 122b may be connected to the first housing 11 by means of the first resilient sub-arm 122a, so that even if the second resilient sub-arm 122b is not fixed and not connected to the first housing 11, deformation of the second resilient sub-arm 122b when the button body 121 is pressed is not affected. That is, when the button body 121 is pressed, the second resilient sub-arm 122b that is not fixed and not connected to the first case 11 can still be deformed, thereby distributing the force applied to the button body 121 of the first sub-button 12a. Meanwhile, since the positioning portion 132 or the fitting portion 1223 is disposed at the fixing end 1222 that is not connected to the first housing 11 or the circuit board 13, that is, since the positioning portion 132 or the fitting portion 1223 is not disposed at the fixing end 1222 connected to the first fixing portion 112 or the circuit board 13, the fixing end 1222 has a sufficient space to be connected to first fixing portion 112 and the circuit board 13. Therefore, the interference of the positioning portion 132 or the fitting portion 1223 on the fixed connection between the fixing end 1222 and the circuit board 13 is avoided, so that the connection reliability between the fixing end 1222 and each of the first fixing portion 112 and the circuit board 13 is ensured.

Similarly, the third resilient sub-arm 122c is connected to the fourth resilient sub-arm 122d through a connecting rib 123. A fixing end 1222 of the fourth resilient sub-arm 122d is connected to the first fixing portion 112. A fixing end 1222 of the third resilient sub-arm 122c is not connected to the first housing 11 through the first fixing portion 112, that is, the first housing 11 is not provided with the first fixing portion 112 connected to the third resilient sub-arm 122c. The fixing end 1222 of the fourth resilient sub-arm 122d is connected to the other end of the circuit board 13 in the first preset direction f1. The fixing end 1222 of the third resilient sub-arm 122c is provided with the positioning portion 132 or the fitting portion 1223. In this way, the third resilient sub-arm 122c may be connected to the first housing 11 by means of the fourth resilient sub-arm 122d, so that even if the third resilient sub-arm 122c is not fixed and not connected to the first housing 11, deformation of the third resilient sub-arm 122c when the button body 121 is pressed is not affected. That is, when the button body 121 is pressed, the third resilient sub-arm 122c that is not fixed and not connected to the first housing 11 can still be deformed, thereby distributing the force applied to the button body 121 of the second sub-button 12b. Meanwhile, since the positioning portion 132 or the fitting portion 1223 is disposed at the fixing end 1222 that is not connected to the first housing 11 or the circuit board 13, that is, since the positioning portion 132 or the fitting portion 1223 is not disposed at the fixing end 1222 connected to the first fixing portion 112 or the circuit board 13, the fixing end 1222 has a sufficient space to be connected to the circuit board 13 of the first fixing portion 112. Therefore, the interference of the positioning portion 132 or the fitting portion 1223 on the fixed connection between the fixing end 1222 and each of the first fixing portion 112 and the circuit board 13 is avoided, so that the connection reliability between the fixing end 1222 and each of the first fixing portion 112 and the circuit board 13 is ensured.

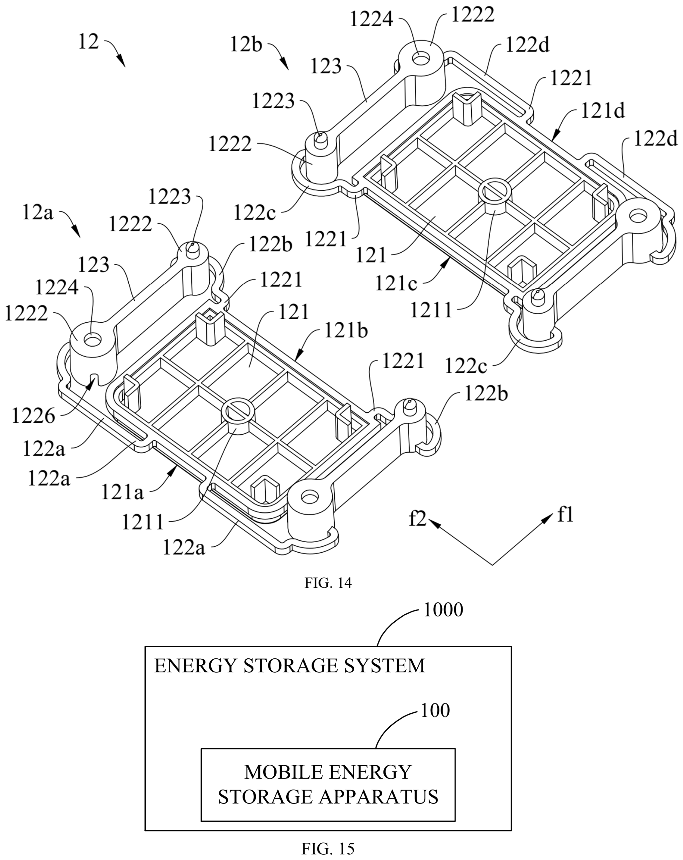

Referring to FIG. 15, an energy storage system 1000 is further provided in an embodiment of the present disclosure. The energy storage system 1000 has the mobile energy storage apparatus 100 in any embodiment described above. Specifically, the energy storage system may include an electricity-consumption apparatus and the mobile energy storage apparatus in any embodiment described above. The mobile energy storage apparatus can be configured to supply power to the electricity-consumption apparatus. It can be understood that, the energy storage system has the described mobile energy storage apparatus can have the same or similar beneficial effect as the mobile energy storage apparatus, and reference can be made to the description of the embodiments of the mobile energy storage apparatus for details, which is not repeated herein.

The technical features in the above embodiments can be combined in any manner. In an effort to provide a concise description, not all of the possible combinations of the technical features in the above embodiments are described. However, any combination of these technical features should be considered within the scope as recited in this specification unless there is a contradiction in such a combination.

Furthermore, the above embodiments only show several implementations of the present disclosure, and the descriptions thereof are relatively specific and detailed, but cannot be understood as a limitation to the scope of the present disclosure. It should be noted that for those of ordinary skill in the art, without departing from the concept of the present disclosure, several modifications and improvements can be made, and these all belong to the protection scope of the present disclosure. Therefore, the contents of this specification shall not be construed as a limitation to the present disclosure, and the protection scope of the present disclosure shall be referred to the appended claims.

## Claims

1. A housing assembly (10), comprising:
a first housing (11), wherein the first housing (11) defines a button via hole (111) communicating an interior of the first housing (11) with an exterior of the first housing (11), and the first housing (11) is provided with a first fixing portion (112) on an inner surface of the first housing (11);
a button structure (12), wherein the button structure (12) comprises a button body (121) and a resilient arm (122), the button body (121) passes through the button via hole (111), the button body (121) is provided with a button protrusion (1211) protruding towards the interior of the first housing (11), the resilient arm (122) is positioned inside the first housing (11), the resilient arm (122) has a connecting end (1221) and a fixing end (1222) opposite to the connecting end (1221) in an extension direction of the resilient arm (122), the connecting end (1221) is connected to the button body (121), and the fixing end (1222) is connected to the first fixing portion (112); and
a circuit board (13), wherein the circuit board (13) is disposed inside the first housing (11) and is positioned at one side of the button structure (12) positioned facing away from the button via hole (111), the circuit board (13) is provided with a control button (131) protruding from a surface of the circuit board (13) positioned facing towards the button structure (12), and the control button (131) is positioned at a position corresponding to the button protrusion (1211); wherein
one of the circuit board (13) and the fixing end (1222) is provided with a positioning portion (132), the other of the circuit board (13) and the fixing end (1222) is provided with a fitting portion (1223), and the fitting portion (1223) is in fit connection with the positioning portion (132).

2. The housing assembly (10) of claim 1, wherein the circuit board (13) abuts against the fixing end (1222) in a depth direction of the button via hole (111).

3. The housing assembly (10) of claim 1, wherein the circuit board (13) is provided with a second fixing portion (133), and the second fixing portion (133) is connected to the fixing end (1222), to make the circuit board (13) fixed inside the first housing (11).

4. The housing assembly (10) of claim 1, wherein the resilient arm (122) is implemented as a plurality of resilient arms (122) arranged at intervals in a circumferential direction of the button body (121); and
the first fixing portion (112) is implemented as a plurality of first fixing portions (112), and the plurality of first fixing portions (112) are respectively connected to fixing ends (1222) of the plurality of resilient arms (122).

5. The housing assembly (10) of claim 4, wherein fixing ends (1222) of any adjacent two of the plurality of resilient arms (122) are connected through a connecting rib (123); or
the number of the resilient arms (122) is an even number, fixing ends (1222) of every two of the plurality of resilient arms (122) are connected through a connecting rib (123), and a fixing end (1222) of each of the plurality of resilient arms (122) is connected to one connecting rib (123).

6. The housing assembly (10) of claim 5, wherein for two resilient arms (122) connected to each other through the connecting rib (123), a fixing end (1222) of one of the two resilient arms (122) is connected to one of the plurality of first fixing portions (112), and a fixing end (1222) of the other of the two resilient arms (122) is not connected to one of the plurality of first fixing portions (112) and is provided with the fitting portion (1223) or the positioning portion (132).

7. The housing assembly (10) of claim 4, wherein the circuit board (13) has a first preset direction (f1) and a second preset direction (f2) that are defined at an angle, and a size of the circuit board (13) in the first preset direction (f1) is larger than or equal to a size of the circuit board (13) in the second preset direction (f2), two ends of the circuit board (13) in the first preset direction (f1) are connected to the first housing (11), the button structure (12) comprises a first sub-button (12a) and a second sub-button (12b) spaced apart from each other in the first preset direction (f1), and each of the first sub-button (12a) and the second sub-button (12b) comprises the button body (121) and the plurality of resilient arms (122);
the button body (121) of the first sub-button (12a) has a first side (121a) and a second side (121b) opposite to the first side (121a) in the first preset direction (f1), and the second side (121b) is closer to the second sub-button (12b) than the first side (121a); and the second sub-button (12b) has a third side (121c) and a fourth side (121d) opposite to the third side (121c) in the first preset direction (f1), and the third side (121c) is closer to the first sub-button (12a) than the fourth side (121d);
the plurality of resilient arms (122) of the first sub-button (12a) comprise a first resilient sub-arm (122a) and a second resilient sub-arm (122b), the first resilient sub-arm (122a) is disposed at the first side (121a), and the second resilient sub-arm (122b) is disposed at the second side (121b); and the plurality of resilient arms (122) of the second sub-button (12b) comprise a third resilient sub-arm (122c) and a fourth resilient sub-arm (122d), the third resilient sub-arm (122c) is disposed at the third side (121c), and the fourth resilient sub-arm (122d) is disposed at the fourth side (121d); and
a length of the first resilient sub-arm (122a) in an extension direction of the first resilient sub-arm (122a) is larger than a length of the second resilient sub-arm (122b) in an extension direction of the second resilient sub-arm (122b), and/or a length of the fourth resilient sub-arm (122d) in an extension direction of the fourth resilient sub-arm (122d) is larger than a length of the third resilient sub-arm (122c) in an extension direction of the third resilient sub-arm (122c).

8. The housing assembly (10) of claim 7, wherein the first resilient sub-arm (122a) and the second resilient sub-arm (122b) are symmetrically disposed, and the third resilient sub-arm (122c) and the fourth resilient sub-arm (122d) are symmetrically disposed.

9. The housing assembly (10) of claim 7, wherein the number of the plurality of first fixing portions (112) is less than the number of the plurality of resilient arms (122);
the first resilient sub-arm (122a) is connected to the second resilient sub-arm (122b) through a connecting rib (123), a fixing end (1222) of the first resilient sub-arm (122a) is connected to a first fixing portion (112), and a fixing end (1222) of the second resilient sub-arm (122b) is not connected to the first housing (11) through a first fixing portion (112); and the fixing end (1222) of the first resilient sub-arm (122a) is connected to one end of the circuit board (13) in the first preset direction (f1), and the fixing end (1222) of the second resilient sub-arm (122b) is provided with the positioning portion (132) or the fitting portion (1223); and
the third resilient sub-arm (122c) is connected to the fourth resilient sub-arm (122d) through a connecting rib (123), a fixing end (1222) of the fourth resilient sub-arm (122d) is connected to a first fixing portion (112), and a fixing end (1222) of the third resilient sub-arm (122c) is not connected to the first housing (11) through a first fixing portion (112); and the fixing end (1222) of the fourth resilient sub-arm (122d) is connected to the other end of the circuit board (13) in the first preset direction (f1), and the fixing end (1222) of the third resilient sub-arm (122c) is provided with the positioning portion (132) or the fitting portion (1223).

10. The housing assembly (10) of claim 1, wherein the button structure (12) comprises a first sub-button (12a) and a second sub-button (12b), each of the first sub-button (12a) and the second sub-button (12b) comprises the button body (121) and the resilient arm (122), the fixing end (1222) of the first sub-button (12a) is configured as a first fixing end (1222a), the fixing end (1222) of the second sub-button (12b) is configured as a second fixing end (1222b), at least one of the first fixing end (1222a) or the second fixing end (1222b) is provided with a first foolproof portion (1226), and the first housing (11) is provided with a second foolproof portion (113) on the inner surface of the first housing (11); and
one of the first foolproof portion (1226) and the second foolproof portion (113) is a foolproof protrusion, the other of the first foolproof portion (1226) and the second foolproof portion (113) is a foolproof slot, and the foolproof protrusion is embedded in the foolproof slot.

11. The housing assembly (10) of claim 10, wherein only one of the first fixing end (1222a) and the second fixing end (1222b) is provided with the first foolproof portion (1226); or
each of the first fixing end (1222a) and the second fixing end (1222b) is provided with the first foolproof portion (1226); and the first foolproof portion (1226) on the first fixing end (1222a) and the first foolproof portion (1226) on the second fixing end (1222b) are different in shape, and/or the first foolproof portion (1226) on the first fixing end (1222a) and the first foolproof portion (1226) on the second fixing end (1222b) are different in size.

12. The housing assembly (10) of claim 10, wherein the first fixing portion (112) is a protrusion protruding from the inner surface of the first housing (11), the second foolproof portion (113) is the foolproof protrusion, and the foolproof protrusion is connected to an outer peripheral surface of the first fixing portion (112); and
a surface, positioned facing away from the circuit board (13), of the first fixing end (1222a) and/or the second fixing end (1222b) is recessed to define a positioning recess (1225), the first foolproof portion (1226) is the foolproof slot in communication with the positioning recess (1225), the foolproof slot extends through the surface, positioned facing away from the circuit board (13), of the first fixing end (1222a) and/or the second fixing end (1222b), the first fixing portion (112) is embedded in the positioning recess (1225), and the second foolproof portion (113) is embedded in the first foolproof portion (1226).

13. A mobile energy storage apparatus (100), comprising a second housing (20), an energy storage unit (30), and the housing assembly (10) of any one of claims 1 to 12, wherein the second housing (20) is connected to the first housing (11), the second housing (20) and the first housing (11) cooperatively define an inner cavity (21) therebetween, the energy storage unit (30) is built in the inner cavity (21), and the circuit board (13) is electrically connected to the energy storage unit (30).

14. An energy storage system (1000) having the mobile energy storage apparatus (100) of claim 13.
